# EUROPEAN PATENT APPLICATION

(11) **EP 1 732 082 A2**
(43) Date of publication of application: **13.12.2006**
(21) Application number: 06011188.7
(22) Date of filing: 31.05.2006
(51) Int. Cl.: G11C 29/04

(54) **A memory architecture with BIST**

(30) Priority: 31.05.2005 IN DE14052005
(71) Applicant: STMicroelectronics Pvl. Ltd., 3 & 18, Sector 16A, Institutional Area Noida, Uttar Pradesh 201 301 (IN)
(72) Inventor: Dubey, Prashant, Indirapuram Ghaziabad, UP (IN)
(74) Representative: Ferrari, Barbara

(57) **Abstract**

This invention relates to a memory architecture with built-in testing mechanism integrated in said memory to support very efficient built-in self-test in Random Access Memories (RAMs) with greatly reduced overhead, in terms of area and speed. A method for in-built testing of a memory architecture is also described.

## Description

### Field of the Invention

The present invention relates to memory architecture.

### Background of the Invention

Technology trends in semiconductor memories follow MOORE's Law and thus every year circuit geometries shrink by roughly a factor of 1.5. Memories are also increasingly used as embedded structures in Application Specific Integrated Circuits (ASICs).

Today's embedded memories are full custom volatile/non-volatile memories that are designed and optimized for high speed, low power and small area. There are two types of embedded memories: synchronous and asynchronous. The operations inside asynchronous memories are not synchronized to a clock. On the contrary, synchronous memories work on the edge of the clock.

Also, volatile memories can be divided based upon the nature of the storage element and detection techniques, into two categories namely: Static Random Access Memories (SRAMs) and Dynamic Random Access Memories (DRAMs). SRAMs contain storage elements that retain the values stored in them until either a power supply is removed or the data is over written. DRAMs on the other hand contain storage elements that require dynamic refreshing at regular intervals to retain the values stored in them.

The following description would be focused on synchronous single port SRAMs, and DRAMs. Nevertheless, the same fundamentals can also be applied to the asynchronous memories in an obvious manner.

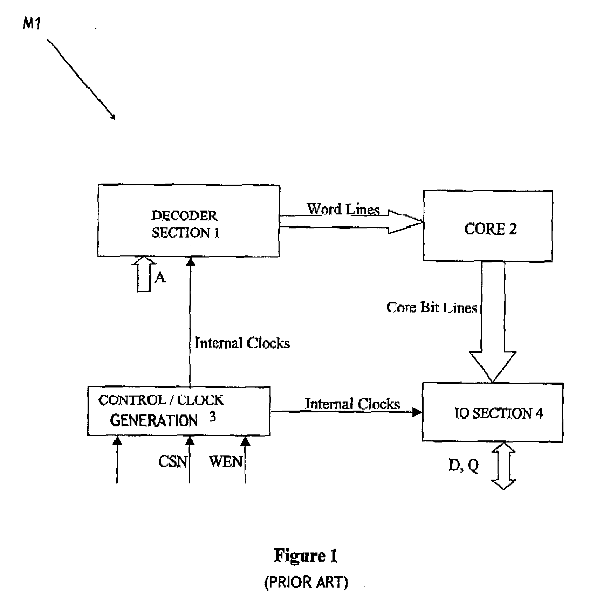

A typical memory essentially comprises a data input port, an address port, a clock, a memory select port, an output enable port, a write enable port and an output port. The block diagram of a RAM memory is shown in Figure 1, globally indicated with M1. More particularly, the memory M1 comprises a decoder section 1, a core section 2, an IO section 4 and a control / clock generation section 3.

The decoder section 1 receives internal clocks from the control / clock generation section 3 as well as a datum A outside of the memory M1 and is connected to the core 2 by a plurality of word lines. The core 2 is in turn connected to the 10 section 4 by a plurality of core bit lines, the IO section 4 receiving a plurality of internal clocks from the control / clock generation section 3 as well.

Moreover, the control / clock generation section 3 receives control signals, such as the well known signals CSN, WEN...

Finally, the IO section 4 is connected outside of the memory M1 in a bidirectional manner and provides/receives signals indicated as D, Q in the figure.

Various electronic blocks or elements like X Decoder, Y Decoder, Pre Decoder, Core, I/O's / Precharge / Read / Write Logic, Clock Generation Circuits, Dummy Paths, Refresh Logic and Pipe Lines are made in form of leaf cells that are abutted to form a memory block of a desired "word x bit" configuration.

The full memory development thus pertains to making these leaf cells with a new technology and tuning them according to the full range of words and bits provided.

The decoder section 1 of the memory usually comprises latches to latch address inputs. The addresses are statically decoded and a valid decoded value is clocked to finally select a row or column (or both) to write onto or read from the corresponding cells.

In case of dynamic decoders, row selection signals called "wordlines" are subjected to a precharge mechanism using an internally generated memory clock. The write unit of the memory can be as simple as a latch to store the value at a data input port on the positive edge of the clock, and a strong buffer to pull the column selection signals called "bitlines" (which are architecture specific) to the latched value.

A writing operation of a DRAM involves a more complex structure as the data to be written on a row is first copied on to a row register and then written into the memory. Periodic refresh cycles are simply read write operations of the DRAM memory cells. The reading circuit can be as simple as a digital inverter Lu sense the discharge of a precharged bitline or as complex as a differential / latch type, single / double ended sense amplifier which is analog in nature.

Moreover, for a DRAM, the reading operation is complex as the reading is destructive. In this case again a latch can be used to hold the value read out from the memory in a particular cycle, until the next operation at the next positive edge of the memory clock.

The core 2 can comprises a group of cells, which can be single latches, or six, four, eight transistor complex latches or a capacitor.

Testing of embedded RAMs is increasingly becoming a bottleneck in the overall quality of the user end ASIC. Current implementations employ a BIST circuit external to the RAM architecture. This known implementation of an external BIST or DFT (Design-for-Testability) mechanism, causes an increase of the setup, hold and access times of the RAM. This creates the problem in timing estimation before the BIST insertion.

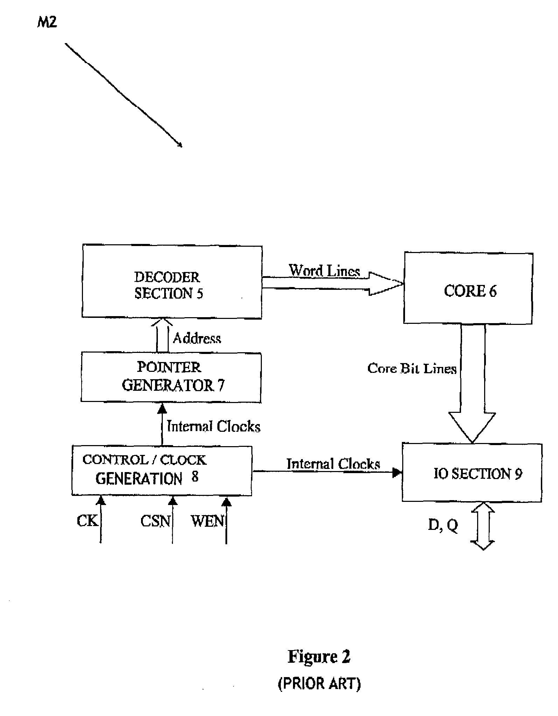

A second type of memory architecture, which is known as a "register file", typically comprises data input ports and address ports for writing operations, data output ports and address ports for reading operations (in case of FIFOs or stacks there are no address ports), an IO section, decoders or counters, pipelines, clock generation circuits (in case of a self timed architecture) and refresh logic. The block diagram of such a register file memory is shown in Figure 2, globally indicated with M2.

More particularly, the memory M2 comprises a decoder section 5, a core 6, a pointer generator 7, a control / clock generation section 8 and an IO section 9.

The decoder section 5 receives address signals from pointer generator 7 and is connected to the core 6 by a plurality of word lines. The core 6 is in turn connected to the IO section 6 by a plurality of core bit lines, the IO section 9 receiving a plurality of internal clocks from the control / clock generation section 3.

Moreover, the control / clock generation section 9 receives control signals, such as the well known signals CSN, WEN... and a clock signal CK and provides a plurality of internal clocks to the pointer generator 7.

Finally, the IO section 9 is connected outside of the memory M2 in a bidirectional manner and provides/receives signals indicated as D, Q in the figure.

A typical structure of this kind of memories, in addition to a structure of a normal memory, comprises:
1. READ DECODER / COUNTERS
2. WRITE DECODER / COUNTERS
3. PRE DECODERS

Usually, a decoder of the register file contains latches for the address and data inputs, write enable or read enable signals. In case of FIFOs or LIFOs there are no address ports as the memory self-generates the addresses sequentially. In case of address ports, addresses arc statically or dynamically decoded and the valid decoded value is clocked to finally select a row or column (or both) to write onto or read from the corresponding cells. Dynamic decoders work in the similar fashion as described above with reference to single port memories.

The pointer generation in the register file memory is a complex operation. In case of a FIFO there are generally two pointers, one is for the reading operations and the other is for the writing operations. At the beginning when there is no data in the FIFO, the position of the write pointer coincides with the position of the read pointer. Once a writing operation is performed, the write pointer marches ahead of the read pointer making space for the read pointer to move further. The FIFO becomes full when the write pointer comes exactly one location behind the read pointer. In this condition further writing operations cannot be performed.

In some situations, half full cases or half empty cases are also generated. To generate an Empty flag, the read pointer and the write pointer are compared to find their equality. To generate a Full flag, the write pointer is compared to the read pointer to determine if the write pointer value is one less than the read pointer value. The major difficulty arises due to the fact that the clocks for the read and write pointers are normally different. In the aforesaid case, the flags act as synchronization signals for the two clock domains.

In case of LIFO, it's always the reverse. The read pointer always moves along with the write pointer when a writing operation is performed. Once a reading operation is performed, the write pointer as well as the read pointer both move backwards. The clocks for the reading and writing operations cannot be different in case of a stack or some complex arrangement has to be made. Thus there are lots of complexities in designing such high speed and best in class register file memories.

Thus despite the fact that the aforesaid memories arc high density, high speed, low power, they have the following disadvantages:
1. These memories cannot test themselves. They need a BIST or some other external circuit on chip or off chip to test them.
2. The fact that they are tested by some external circuit increases the effort on the user end in terms of:
   a. Place & Route
   b. Timing Analysis before and after a test circuit insertion
   c. Clock management
3. The routing congestion as well as placement constraint is sometime painful for the user integrating test with memory.
4. In case the user wants to achieve a particular speed for the integrated test to be able to perform at-speed test, an extra area is needed which also increases the routing congestion due to extra clock buffering and routing.
5. The test algorithms in an external test mechanism are most of the times coded to get the best fault coverage, based upon the fault model chosen upon various criteria like, Memory architecture, Process, Technology, Memory size etc. But as the process changes or gets matured, the need of a very exhaustive fault model, decreases. Thus there must be a procedure to alter the algorithm of the test mechanism.
6. Most of the times, external test patterns are needed to test the BIST or the test circuitry itself, before using it to test the other blocks. These tests are an additional cost over the existing set of test patterns, in terms of extra time as well as extra tester memory/register file.
7. Another thing is that these memories are present on chip in large numbers and some time scattered around the chip. Thus sharing the test mechanism is a tedious job and it also increases the routing congestion.
8. Another problem is that the size for which these memories are used are very small. Thus they are high speed as well as have very little area. Any test mechanism provided dedicatedly for these memories is normally 200% to 800% of the memory itself in terms of area occupation. Although there are some serial test mechanisms which use scan registers to test the memories, but then a lot of time is taken to write and read in the memory through scan chains as the scan chains on the SOC's are very long. Also the test cannot be a very high-speed test as serial scan chains are routed for a very low speed.
9. The test mechanism has to ensure the correctness of a general functionality from all the ports as well as the at-speed functionality. The known fault models, which are particular about the dual port operation, are Disturb faults, as well as memory cell stability tests.
10. External tcst mechanisms so provided do not increase the observability of the system pins, which are going to the register file.

The present invention aims at providing a memory architecture, which solves all the above outlines problems simultaneously and does overcome the above-mentioned disadvantages of the known memory architectures.

### Summary of the Invention

The solution idea underlying the present invention is that of providing a memory architecture with a built-in testing mechanism integrated in the memory architecture.

On the basis of such solution idea the technical problem is solved by a memory architecture as previously indicated and defined by the characterizing part of claim 1.

The problem is also solved by a method for in-built testing of a memory architecture as defined by the characterizing part of claim 16.

### Brief Description of the Drawings

The invention will now be described with reference to the accompanying drawings.
Figure 1 shows a single port memory realized according to the prior art.
Figure 2 shows a register file memory realized according to the prior art.
Figure 3 shows a block diagram of a memory architecture according to the present invention.
Figures 4-8 show different details of the memory architecture of Figure 3.
Figure 9 shows an inner pattern generated in the memory architecture of Figure 3.

### Detailed Description of the Invention

The invention generally relates to a high-speed memory architecture, which uses a built-in structured DFT (Design-for-Testability) technique to test itself, thus reducing the effort of using DIST or any other DFT technique. In this way, the user is saved from putting extra efforts in timing analysis twice, as in the known solutions. The effort of BIST insertion is also reduced.

In particular, as will be clear from the following description, all the disadvantages related to test and initialization of the core of full custom memories, as above mentioned, have been taken care of. From design to test, the memory architecture of the present invention is a complete memory solution for a high-speed embedded RAM that has been designed while keeping the testing aspect in mind, thus resulting in an efficient architecture.

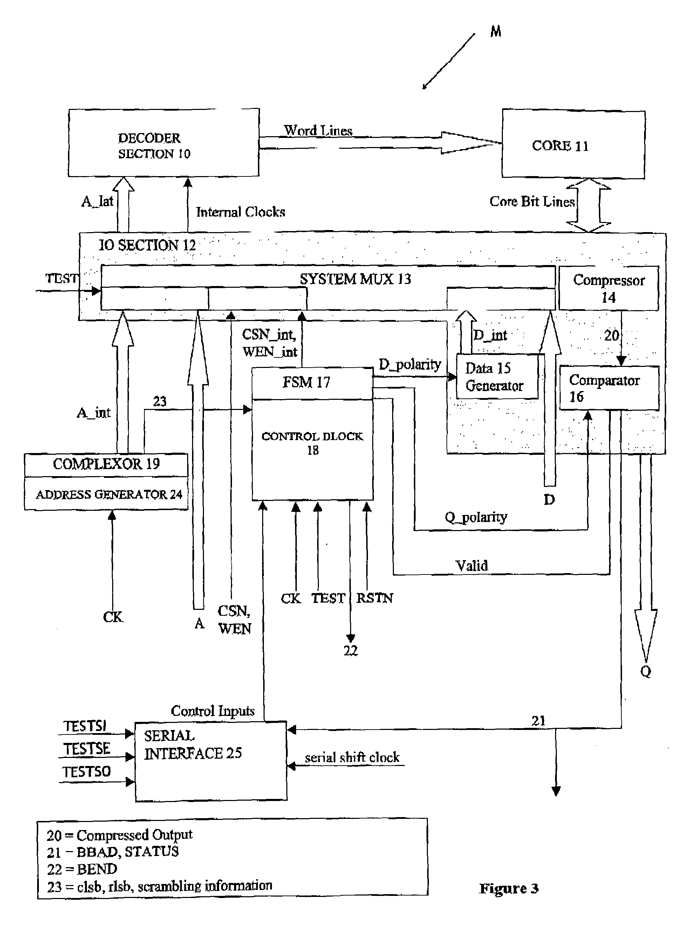

The memory architecture according to the invention is shown in Figure 3, globally indicated with M. It should be noted that the memory architecture M comprises test pins along with minimal hardware, which are added to a classical memory interface. In particular, through the test pins indicated as TESTSE, TESTSI & TESTSO a test mechanism is configured inside the memory architecture itself.

The memory architecture M also comprises a TEST pin which is used to distinguish between a functional mode (transparent mode) and a test mode.

More particularly, the memory architecture M comprises a decoder section 10, a core 11 and an IO section 12.

The decoder section 10 receives a latched address signal A_lat as well as internal clocks from the IO section 12 and is connected to the core 11 by a plurality of word lines. The core 11 is in turn connected to the 10 section 12 by a plurality of core bit lines. The decoder section 10 thus comprises at least one decoder.

Advantageously according to the invention, the IO section 12 comprises a System Multiplexer 13 connected to the TEST pin, a Compressor 14 connected to a Comparator 16 and a Data/Pattern Generator 15 providing the System Multiplexer 13 with an inner data signal D_int. The System Multiplexer 13 also receives control signals CSN and WEN and an input data signal D. Furthermore, the IO section 12 provides an output data signal Q.

The memory architecture M further comprises a Control Block 18 receiving a clock signal CK, a reset signal RSTN and a test signal TEST through the TEST pin.

Advantageously according to the invention, the Control Block 18 comprises a FSM (Finite State Machine) 17 connected to the Comparator 16 to which it provides a first polarity signal Q_polarity as well as to the Data/Pattern Generator 15 to which it provides a second polarity signal D_polarity. The FSM 17 is also connected to the System Multiplexer 13 and provides it with inner control signals CSN_int and WEN_int.

Moreover, the Control Block 18 is connected to a Complexor 19 of an Address Generator 24 which receives the clock signal CK. The Complexor 19 is also connected to the System Multiplexer 13 of the IO section 12 and provide it with an inner address signal A_int. The System Multiplexer 13 is configured using tristate buffers.

Furthermore, advantageously according to the invention, the memory architecture M comprises a Serial Interface 25 connected to the test pins, TESTSI, TESTSE and TESTSO, and receiving a serial shift clock. The Serial Interface 25 is also connected to the Comparator 16 and to the Control Block 18 to which it provides control inputs.

In particular, the Compressor 14 has an output line 20 connected to the Comparator 16 and providing a compressed output signal , the Comparator 16 has an output line 21 connected to the Serial Interface 25 and providing BBAD and STATUS signals, the Control Block 18 ha an output line 22 providing a BEND signal and the Complexor 19 has an output line 23 connected to the Control Block 18 and providing an information signal.

In a general manner, as will be explained in a more detailed manner in the following description, the memory architecture M according to the invention has an integrated built-in testing mechanism and essentially comprises:
- a Memory Core 11 for storing data;
- a Decoder Section 10 connected to the Memory Core 11 for decoding addresses;
- an I/O Section 12 connected to the Memory Core 11 for bidircctional shifting of data; and
- a Control Block 18 connected to the I/O Section 12 and the Decoder Section 10 for generating control signals and internal clock.

Advantageously according to the invention, the I/O Section 12 and the Control Block 18 are enhanced to be configurable for built-in testing in test mode by comprising:
- a configurable Serial Interface 25 connected to the Control Block 18 for shifting in and out test data and test status;
- a configurable Test Address Generator 24 within the I/O Section 12 connected to the Decoder Section 10 and having a plurality of Flip/Flops being configured using the latches present in the I/O Section 12;
- a configurable Test Pattern Generator 31 within the I/O Section 12 for generating test patterns on address and/or data lines during a test mode;
- a configurable Test Result Comparator 16 within the I/O Section 12 for comparing Memory data output with the test/expected data during the test mode; and
- a configurable Test Sequence Generator within the I/O Section 12 connected to the Test Pattern Generator 31 and the Test Result Comparator 16 for providing the verified result,

The operation of the various blocks comprised into the memory architecture according to the present invention is as follows.

A data to be run is programmed in the Serial Interface 25. This data consists of information like, pattern type, number of operations, type of operations, address directions, LFSR seed etc. and is shifted at the speed of the serial shift clock received by the Serial Interface 25, through serial inputs. The TEST pin is made high, to activate the FSM 17, which generates various controls for the other blocks based upon the control inputs from the Serial Interface 25.

In particular, the Address Generator 24 generates the address, based upon FSM 17 controls and Serial Interface 25 controls like, initial address and final value, address direction, LFSR seed.

Data/Pattern Generator 15 generates the data inputs based upon the FSM 17 controls and serial interface controls like data polarity, data background, scrambling information from the address generator, data pattern type etc. The Data/Pattern Generator 15 generates the controls based upon the FSM 17 controls and serial interface 25 controls like operations to be performed (reading/writing operations), memory to be selected or not and the required port to be activated.

Complexor 19 creates difference between various port addresses in case a duplex operation or a multiplex operation is to be performed. In particular, the Complexor 19 in a multi port memory configuration is used to synchronize test operations over multiple ports and to perform simultaneous operations on the multi-port memory.

The Compressor 14 compresses the memory output and Comparator 16 compares at each valid output data signalled by the FSM 17. The result is either brought directly at the memory output or loaded in the Scrial Interface 25. In other words, the Compressor 14 compresses the data prior to forwarding to the Comparator 16.

The System Multiplexer 13 selects the Memory functional inputs coming from the system or the test inputs generated from the embedded test circuitry. The System Multiplexer 13 thus multiplexes external address bus and internal test address bus.

For a single test the Serial Interface 25 can be configured like above and then the embedded circuitry can run the test on the memory, and generate status for each test and pass it to the Serial Interface 25.

The connection of various sub-blocks blocks can be adjusted according to the memory architecture. In case of a memory device having only one bank, the address decoder as well as control unit of the memory are usually on one side of the memory.

Advantageously according to the invention, the Address Generator 24 is put just below the address decoder to minimize the routing and connection overhead. This also makes the address generation faster as there are lesser interconnect delays.

In case of Paged memory architecture (DRAM), the Compressor 14 and the Comparators 16 can be put per page while the Address Generators 24, FSM 17 and other logic can be shared or duplicated for each page as per the speed needed.

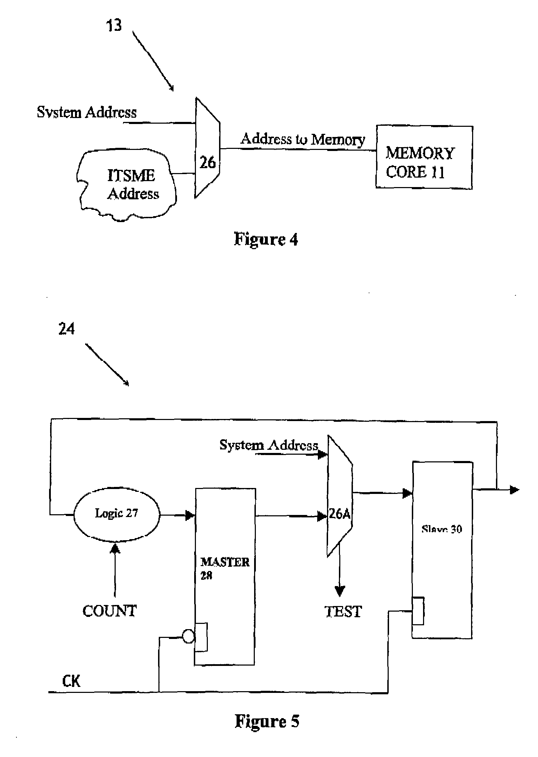

Figure 4 shows in greater detail the System Multiplexer 13 of the memory architecture M according to the present invention. The System Multiplexer 13 is connected to the system pins and the test inputs for receiving the memory address and test address generated by the Complexor 19. A multiplexer 26 of the System Multiplexer 13 according to the invention is connected to the external TEST pin and receives an enable signal therefrom.

A similar multiplexer configuration is used for the memory pins interacting with the system. These multiplexers are technology independent and minimum number of the same is required as they result in additional delay in the setup time of the memory architecture.

Advantageously according to the invention, the Serial Interface 25 is used to shift data in the test mode. The data to be shifted may include the type and the number of operations to be performed on each address, the seed of the Linear Feedback Shift Register (LFSR), the data to be written on the memory, the data pattern (checkerboard, stripes etc.), the memory section on which the test has to be run, etc.

The serial shift clock can be any clock depending upon the usage and the environment.

The Serial Interface 25 may be internal or external to the memory and can be shared between several memories. The information is shifted in serially at a very low clock speed.

Figure 5 shows in greater detail the Address Generator 24 which is used for generating the test address for the memory and is therefore a Test Address Generator. Deterministic, exhaustive or pseudo-random counters are used for address generation.

Additionally, the Serial Interface 25 can be used to configure the Address Generator 24 to produce a particular sequence of addresses. This helps in detecting the memory faults that are sequence dependent.

The Address Generator 24 can also be configured to produce a single address for writing galloping patterns etc.

The Address Generator 24 comprises a logic 27 receiving a COUNT signal and connected to a master latch 28, which receives the clock signal CK and is connected to a multiplexer 26A, in turn receiving a system address signal and being connected to a slave latch 30. The slave latch 30 receives the clock signal CK and has an output feedback connected to the logic 27.

It should be noted that the Address Generator 24 provides additional test reliability being made using the memory latches already present inside the memory.

In the test mode, the memory latch acts as a slave latch 30 and is combined with the master latch 28 present in the test unit to form a scanable Flip-Flop. The system observability is increased by putting a scan multiplexer on the buses and signals coming from the system.

Hence, this arrangement increases the testability of the memory and reduces the required area for the Address Generator 24. The same arrangement is used for the other pins like, write enable, read enable, data ports etc.

In case of a pointer based on a FIFO or a LIFO, the generation of address is much easier and it is much relevant to test the memory using the pointer generation circuitry of the memory itself.

The reason behind this is that pointers are generated normally in gray codcs due to which the fault model uf such a FIFO is different from a memory, which is counting in Binary Coded Decimal. The operation of a test sequence for one location may not be totally linked with the operation on the next location. But then testing with any other sequence will be irrelevant and it may lead to over testing or under testing. Using the pointer of the memory itself also saves a lot of arca.

The Data Generator 15 generates the data based on the data polarity signal D_polarity and sequence configured through the Serial Interface 25.

Data patterns like checkerboard and stripes have to be written in the memory in order to catch coupling and other faults in the memory. The Address Generator 24 is responsible for producing all test patterns for comprehensive testing of the memory and is therefore also a Test Pattern Generator.

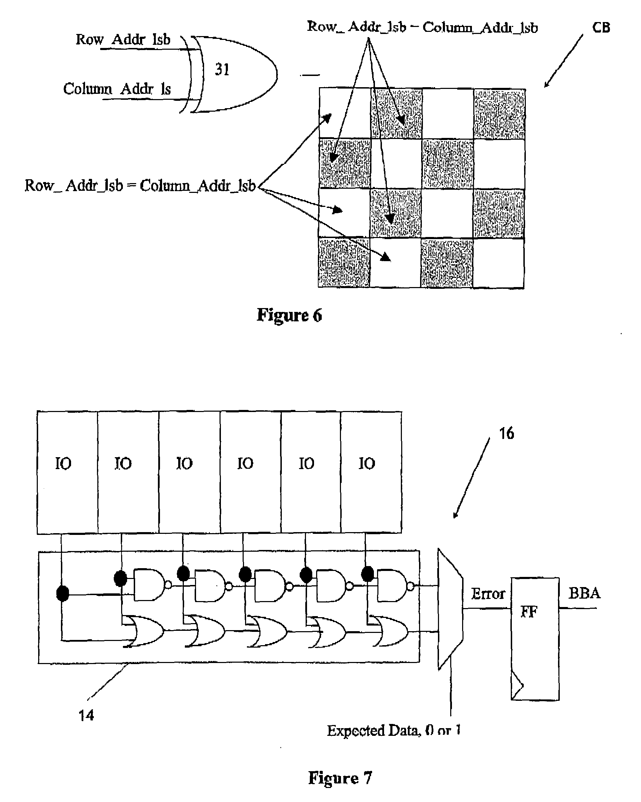

For instance, the generation of checkerboard pattern CB is done by using a single XOR gate 31 for generic row column based memory as shown in Figure 6. The XOR gate 31 is thus a Test Pattern Generator. In an alternative manner, the Test Pattern Generator 31 is realised by a Linear Feedback Shift Register.

It should be remarked that some patterns like checkerboards produce electrical stress on the surrounding locations and are more helpful in testing memories like DRAM where the coupling effects can alter the data. On the other hand, solid data patterns can be important for memories like SRAM.

For data generation block, the data latch of the memory are turned into the Flip-Flops by adding a master latch to the address generator, thus resulting the in a very high-speed memory test. Additionally, as these Flip-Flops are scannable they add observability on the input data pins from the memory.

Also during the memory bypass to improve the shadow logic, there is an asynchronous write through, which puts the data on D bus coming from the system on the Q output bus of the memory. In case the memory is Bit Write or having a mask port, the special patterns can be generated on the mask port of the memory in the same way as the data port.

In case of the bit write ports test it is possible to create a simultaneous read and write on the nearby locations, which can create disturb faults inside the memory. There is no other way of creating this kind of scenario in a single port memory.

The Control Block 18 generates control signals for testing of the memory. These control signals include signals for read or write operations on the memory, reset signals for the memory state machine, disable control signal for the memory self time control, etc.

These control signals are generated during the run time in the test mode. Similar to other blocks, the control latches are changed to flipflops and hence, the observability is increased on the system pins. These control inputs are controlled through the FSM 17.

In case of register file memories, the Control Block 18 controls the operation from all the ports in case of simultaneous operations. Also all the ports can have the same address on their address inputs but the control of operation is done through this port.

In case of a read through a port while writing, the Control Block 18 generates a signal, which stops the comparison of the output data, as the read operation is invalid.

The Control Block 18 is advantageously programmed though the Serial Interface 25 for any control generation.

The FSM 17 is responsible for controlling all activities for the test device. On receiving a high signal at the TEST pin, the FSM 17 resets and initializes all the registers in other blocks of the test device.

Additionally, setting TEST enable pin low synchronously resets the FSM 17 to initial state in next clock cycle.

To attain the maximum operation speed, the FSM 17 is designed in a gray code (two neighbor states differ by only one bit). The states in the State machine are n bits wide where n depends on the number of address sequences tested in one run.

The value and type of the sequences run on the memory are advantageously configured through the Serial Interface 25 serially.

The FSM 17 is only responsible for counting the number of such sequences and responsible for activating or deactivating each block in an ITSME device by controlling the control generator for generating various control signals.

An external signal BEND is set high after all the test sequences have been applied on the memory. This is an indication that the configured series of sequences have been applied and further tests can be carried by configuring new sequences.

The Compressor 14 is used for compressing the data before comparison to reduce the size of the comparator.

For the patterns generated through an LFSR, the Compressor 14 can be as simple as a Multiple Input Signature Register (MISR), which compresses the output to a known signature configured through the Serial Interface 25.

The MISRs are also made by changing the memory output latch to a Flip-Flop in the self-test mode. A MISR polynomial compresses the selected data bit outputs to a single signature.

The MISR polynomial is configurable and is chosen based on the data bit length for the test purpose, which can also be advantageously configured through Serial Interface 25. Thus different types of debugging are also possible by configuring a suitable MISR polynomial.

For deterministic data, the Compressor 14 is made very small making it more suitable for the memories where test algorithms are mostly deterministic. Thus the data output either consists of checkerboard or a solid pattern or a known repeated patterns. These are first compressed to all zeros or all ones, by using NAND - NOR chains. The Compressor 14 is essentially a chain of logic gates.

Different techniques and logics can be used but at the end all the data outputs are compressed to a single bit, which is compared with the expected data bit. The different compressors are used based on the memory floor plan and architecture. To save area, the compressors can be shared between various pages of the memory as well.

The Comparator 16 compares the compressed data, either a signature or a deterministic set of bits, with a golden signature or known data, which is received from the Serial Interface 25.

The signature comparison normally happens at the end of a test run, but the deterministic data comparison can happen on every cycle. Thus the FSM 17 provides the expected data on each clock cycle, which is advantageously configured through the Serial Interface 25.

In this case, a dynamic comparison is done on each clock cycle and in case of a mismatch, the BBAD pin goes high for one clock cycle. At the end of the test if a fault has occurred, then the BBAD pin remains high to signify that the memory is faulty.

The schematic of a generic Compressor 14 and Comparator 16 is shown in Figure 7. The figure illustratcs the case where the memory is filled with either all zeros or all ones. In case of a checkerboard pattern the output Q bus is still all zeroes or all ones and comparison is easily done using a NAND-OR chain. If the Q output bus itself has a checkerboard or repeated patterns, then NAND-OR blocks can be used for all odd bits and even bits separately without putting any extra logic. Hence, the Compressor 14 logic does not increase based on the complexity of the repeated data background.

For a pscudo-random pattern, the pattern itself is given on the D system bus and the expected data is generated by XORing the pattern present on the D input bus of the memory, with Q output bus to produce all zeros or all ones. After this, compression is done to get a single bit in the same manner.

This method involves putting a particular pattern on the D bus, which can increase the testing time by shifting the D patterns on the D bus. This type of pattern (galloping) is good for debugging purposes.

A good testable device always has a proper mechanism for initialization of all blocks on the device. All the sequential devices on a chip must be resetable and must contain known data on all blocks before test. To achieve this inside the architecture has a dedicated unit called Unit for reset management (URM).

This unit is used for asynchronous Reset / Preset of the full memory including all the flip-flops, latches and the core of the memory through a Reset pin (active low). It is also used to initialize the memory with checkerboard pattern or a known pattern present on the D bus.

Figure 5 shows in greater detail the Complexor 19 which is primarily used with the register file memories. The Complexor 19 is used to synchronize patterns in case of a simultaneous operation on nearby locations, more than one port.

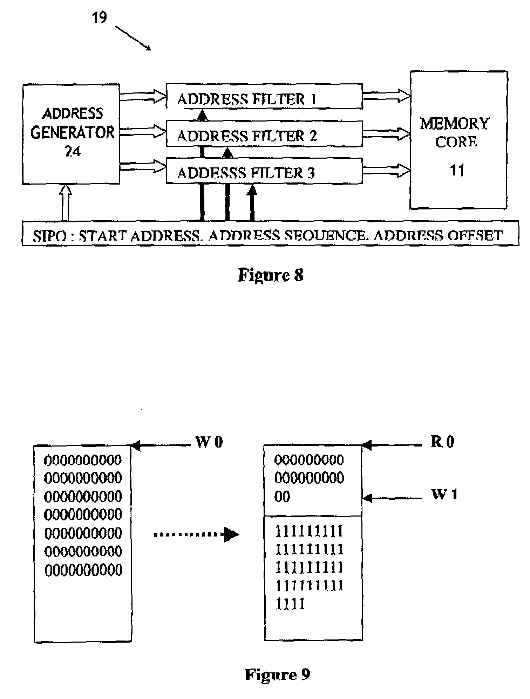

This is done to test the memory for the faults, which occur during functional run. Also these types of operations create a stress on the register file memories which are called disturb faults. The patterns, which are created, are called concurrent patterns. As shown in Figure 8, the Complexor 19 comprises two basic parts, namely an Address Filter and a Qpolarity Filter.

The Address Filter generates addresses of various ports based upon the configuration. For example, if there are three ports (two read and one write), then there can be nine possible arrangements of the ports in terms of their start addresses, which can be easily calculated, based upon the permutation/combination.

The sequence of the ports can be calculated based upon the difference of the port address from the first port address. Though this leads to duplicity but it reduces a lot of area, as this information is low speed information.

To program the nine address sequences one needs four bits.

The difference between one port and the other port should not be greater than a programmed value, which is normally 1 to get better coverage, but it can be at most 2.

Thus to tell the difference one can have two bit per port as there are three ports and the maximum value can be four. Thus by programming only six bits one can generate the address using the address filter block. There is one address filter per port.

The Qpolarity Filter is needed as the address ports run in a rotation. When there is a difference between the port addresses, all the ports count the same number of addresses. The qpolarity is the polarity of data written previously on a location or in some previous clock cycle. This is the data expected on that location.

The only complexity arises when the read operation takes place on an address when a write operation with a different polarity than expected has happened in the current test algorithm run. The polarity correction has to be done in this case.

It is important to note that the polarity correction is only needed when the polarity of expected read is different from the write data polarity happening in the current test algorithm.

For example, there is one write port and one read port there is a difference of two addresses in both the ports. Also lets assume that write port is ahead of read port. The write port is writing one on all the locations as well as the previous written pattern was zero. Thus the qpolarity will be zero for the first two locations while one for the rest of the locations as shown in Figure 9.

The qpolarity filter thus generates a complex expected data based upon the port difference and port sequence coming from the Serial Interface 25.

In essence, the method for in-built testing of configurable memory architecture comprises the following steps of:
- storing data in a memory core;
- decoding the addresses in a decoder section;
- shifting data bi-directionally; and generating control signals;
wherein
- shifting in and out test data and providing test status;
- configuring Latches into Flip/Flops for generating addresses;
- generating test patterns for addresses during test mode; and
- comparing test data with test pattern for providing verified result.

To conclude, the memory architecture according to the invention is a solution worth using inside the embedded memories whether they are asynchronous or synchronous, static or dynamic, soft or hard. The key point of this invention is that it treats the memory not as a macro but moves inside to see the things in detail.

Also, advantageously according to the invention, no external BIST are to be put inside a chip to test the memory.

The area is of course better and hence the timings also. Testability is increased and the full memory is no more a black box. Only the core, which is treated, as black box is isolated during test.

In particular, while in this approach there is lesser area overhead as compared to an external BIST since the test core added is full custom as well as the memory architecture is modified to achieve area and timing performance.

The proposed memory architecture is aimed to a better access and cycle time and having a very little impact on address setup and hold with respect to clock. The power consumption is nearly the same.

Also the need for a sophisticated tester is also eliminated as all the test patterns (including the self test) are generated with in the chip itself or it can be done through a simple TAP or P1500 or some other serial or parallel interface.

Advantageously according to the invention, a memory architecture with a highly optimized in-built testing mechanism in terms of area and speed is provided.

Moreover, the system level testability is increased and the memory core is reset as well as the memory is initialised with a known pattern.

Finally, advantageously according to the invention, the routing congestion of the memory architecture is reduced.

In summary, the present invention relates to configurable memory architecture with a built-in testing mechanism integrated in the memory to support very efficient built-in self-test in Random Access Memories (RAMs) with greatly reduced overhead, in terms of area and speed.

Memories can fail at high speed due to glitches (unwanted pulses which can at times behave as invalid clocks and destroy the functionality of synchronous systems) produced in decoding, the slow precharge of bitlines or the slow sensing of the sense amplifiers.

Advantageously according to the invention, the proposed memory architecture incorporates structured DFT techniques to detect all these failure separately.

## Claims

1. A memory architecture (M) comprising:
- a Memory Core (11) for storing data;
- a Decoder Section (10) connected to said Memory Core (11) for decoding addresses;
- an I/O Section (12) connected to said Memory Core (11) for bidirectional shifting of data; and
- a Control Block (18) connected to said I/O Section (12) and said Decoder Section (10) for generating control signals and internal clock :
wherein said I/O Section (12) and said Control Block (18) are enhanced to be configurable for built-in testing in test mode by comprising:
- a configurable Serial Interface (25) connected to said Control Block (18) for shifting in and out test data and test status;
- a configurable Test Address Generator (24) within said I/O Section (12) connected to said Decoder Section (10) having a plurality of Flip/Flops being configured using the latches present in said I/O Section (12);
- a configurable Test Pattern Generator (31) within said I/O Section (12) for generating test patterns on address and/or data lines during Test mode;
- a configurable Test Result Comparator (16) within said I/O Section (12) for comparing Memory data output with said test/expected data during Test mode; and
- a configurable Test Sequence Generator within said I/O Section (12) connected to said Test Pattern Generator (31) and Test Result Comparator (16) for providing the verified result.

2. The memory architecture as claimed in claim 1 further including a System Multiplexer (13) within said I/O Section (12) for multiplexing between external address bus and internal test address bus.

3. The memory architecture as claimed in claim 2 wherein said System Multiplexer (13) is configured using tristate buffers.

4. The memory architecture as claimed in claim 2 further including a Data Compressor (14) connected to said System Multiplexer (13) for compressing the data prior to forwarding to said Test Result Comparator (16).

5. The memory architecture as claimed in claim 4 wherein said Data Compressor (14) is a chain of logic gates.

6. The memory architecture as claimed in claim 4 wherein said Decoder Section (10) contains at least one decoder.

7. The memory architecture as claimed in claim 1 wherein said Test Pattern Generator (31) is an XOR gate.

8. The memory architecture as claimed in claim 1 wherein one of said Test Patterns is a checkerboard data pattern (CB).

9. The memory architecture as claimed in claim 1 wherein said Test Pattern Generator (31) is a Linear Feedback Shift Register.

10. The memory architecture as claimed in claim 1 wherein said memory architecture is a single port memory.

11. The memory architecture as claimed in claim 1 wherein said memory architecture is a multiple port memory.

12. The memory architecture as claimed in claim 4 further including a Data Complexor (19) within I/O Section (12) in a multi port memory configuration to synchronize test operations over multiple ports and perform simultaneous operations on the multi-port memory.

13. The memory architecture as claimed in claim 1 wherein, in multi-port memory said Test Address Generator (24) is the inherent Pointer Register logic.

14. The memory architecture as claimed in claim 1 further including a Reset Section (URM) for resetting the data of said memory during test initialization.

15. The memory architecture as claimed in claim 1 wherein scan multiplexer is included to buses to increase the observability of the system.

16. A method for in-built testing of a memory architecture comprising the steps of:
- storing data in a memory core (11);
- decoding the addresses in a decoder section (10);
- shifting data bi-directionally; and
- generating control signals;
wherein
- shifting in and out test data and providing test status;
- configuring Latches into Flip/Flops for generating addresses;
- generating test patterns for addresses during test mode; and
- comparing test data with test pattern for providing verified result.
